# EUROPEAN PATENT APPLICATION

(11) **EP 4 258 326 A1**
(43) Date of publication of application: **11.10.2023**
(21) Application number: 23166493.9
(22) Date of filing: 04.04.2023
(51) Int. Cl.: H01L 21/56, H01L 23/495, H01L 25/16, H01L 23/31, H01L 21/60

(54) **FIVE-SIDE MOLD PROTECTION FOR SEMICONDUCTOR PACKAGES**

(30) Priority: 08.04.2022 US 202217658611
(71) Applicant: NXP B.V., 5656 AG Eindhoven (NL)
(72) Inventor: Mao, Kuan-Hsiang, 5656AG Eindhoven (NL); Chuang, Wen Yuan, 5656AG Eindhoven (NL); Huang, Wen Hung, 5656AG Eindhoven (NL)
(74) Representative: Hardingham, Christopher Mark

(57) **Abstract**

Five-side mold protection for semiconductor packages is described. In an illustrative, non-limiting embodiment, a semiconductor package may include: a substrate (403) comprising a top surface, a bottom surface, and four sidewalls; an electrical component (407) comprising a backside and a frontside, where the frontside of the electrical component is coupled to the top surface of the substrate; and a molding compound (411), where the molding compound encapsulates the backside of the electrical component and the four sidewalls of the substrate.

## Description

This disclosure relates generally to semiconductors, and more specifically, to five-side mold protection for semiconductor packages.

### Background

Semiconductor packages are metal, plastic, glass, or ceramic casings containing semiconductor devices or integrated circuits (ICs). Typically, semiconductor devices or ICs are fabricated on a semiconductor wafer before being diced into individual die, tested, and packaged.

A semiconductor package provides a mechanism for its internal devices or ICs to access their external environment, such as a Printed Circuit Board (PCB), via leads (e.g., solder bumps)-and it also protects those devices or ICs against mechanical impact, chemical contamination, and light exposure.

### Brief Description of the Drawings

The present invention(s) is/are illustrated by way of example and is/are not limited by the accompanying figures, in which like references indicate similar elements. Elements in the figures are illustrated for simplicity and clarity and have not necessarily been drawn to scale.
FIG. 1 is a cross-sectional view of a conventional semiconductor package.
FIG. 2 is a flowchart of a conventional process for fabricating a conventional semiconductor package.
FIG. 3 is a flowchart of an example of a process for fabricating a semiconductor package with five-side mold protection, according to some embodiments.
FIGs. 4A-E are cross-sectional views illustrating examples of selected operations of a process for fabricating a semiconductor package with five-side mold protection, according to some embodiments.
FIGs. 5A and 5B are cross-sectional views illustrating examples of electronic devices with semiconductor dies in a flip chip configuration having semiconductor packages with five-side mold protection, according to some embodiments.

### Detailed Description

The following sets forth a detailed description of a mode for carrying out the invention. The description is intended to be illustrative of the invention and should not be taken to be limiting. In this description, the use of relational terms, such as "first" and "second," "front" and "back," "top" and "bottom," "over" and "under," etc. are used to distinguish one entity or action from another entity or action without necessarily requiring or implying a permanent relative position between such entities or actions. Also, some of the figures may be illustrated using various shading and/or hatching to distinguish the different elements produced within the various structural layers. These different elements within the structural layers may be produced utilizing current and upcoming fabrication techniques of depositing, patterning, etching, and so forth. Accordingly, although different shading and/or hatching is utilized in the illustrations, the different elements within the structural layers may be formed out of the same or different materials.

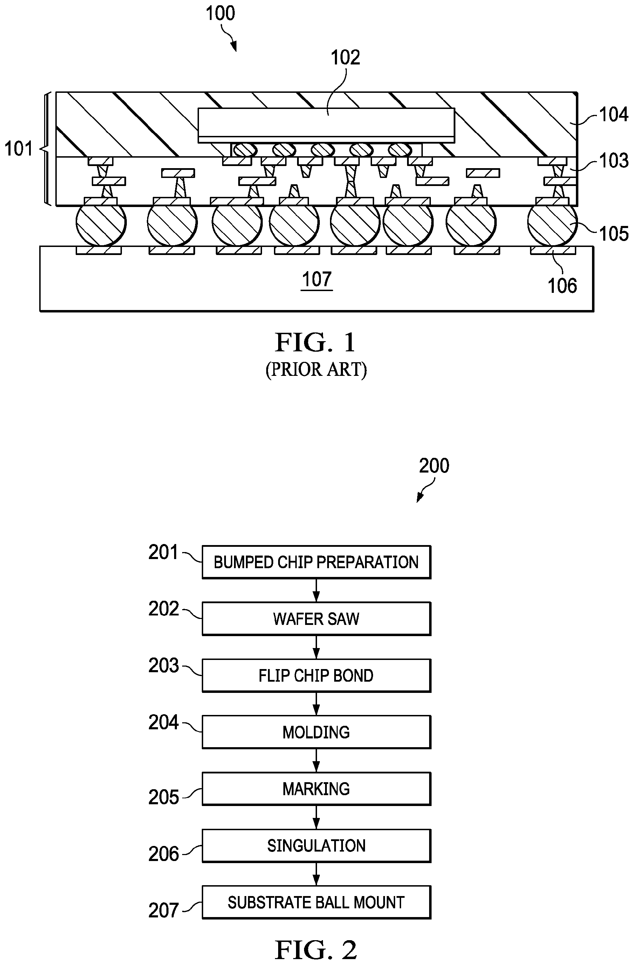

FIG. 1 depicts conventional semiconductor package 100 ("Prior Art"). In this example, package 100 uses flip chip technology, also referred to as Controlled Collapse Chip Connection (C4). Particularly, package 100 includes semiconductor die 101 attached with its frontside (i.e., the active side that includes active circuitry and a plurality of die pads connected to the active circuitry) facing the top surface of substrate 102. Substrate 102 includes patterned conductive features including re-distribution (RDL) layer 103. Electrical contacts at the bottom of RDL layer 103 have solder bumps 105 formed thereon, which are coupled to pads 106 of Printed Circuit Board (PCB) 107 to provide access to electrical circuits within semiconductor die 101.

As shown in FIG. 1, the backside of semiconductor die 101 (the passive side without electrical contacts) is encapsulated by mold compound 104 (e.g., a plastic, resin, polymer, etc.). It should be noted that, in conventional semiconductor package 100, mold compound 104 is coextensive with top surface 108 of substrate 102 and leaves its sidewalls 109 exposed (e.g., 4 sidewalls in the case of a cuboid shape). As such, mold compound 104 only covers die 101 on substrate 102, but it does not protect lateral surfaces 109 of substrate 102.

FIG. 2 is a flowchart of conventional process 200 for fabricating conventional semiconductor package 100 ("Prior Art"). Process 200 begins at 201 with the preparation of bumped chips on a semiconductor wafer. At 202, process 200 includes sawing the wafer. At 203, process 200 creates flip chip bonds on each chip, followed by compound molding at 204 to form a corresponding package. At 205, process 200 includes marking each molded package. At 206, process 200 singulates each molded package, and at 207 process 200 forms ball mounts on the bottom surfaces of the substrates of the singulated packages.

In contrast with FIGs, 1 and 2, systems and methods described herein may provide mold protection to 5 sides of a semiconductor package: the backside of a semiconductor die in a flip chip configuration and the sidewalls of the substrate to which the semiconductor die is attached. Using these systems and methods, a flip chip package may have a more robust structure and improved reliability due to greater thermal-mechanical stress resistance and electrical isolation from other chips on the same board.

In various embodiments, systems and methods described herein may provide 5-side mold protection of flip chip packages (of any flip chip technology) and additional physical and electrical isolation from other flip chips in each application. These system and methods may provide for molded flip chip packages that are attached to an embedded substrate carrier, bumped (wafer level chip scale packaging/fan-out) chips, or passive electronic components (e.g., resistors, capacitors, inductors, etc.), therefore being particularly well-suited for heterogeneous integration. Moreover, these systems and methods may also enable high manufacturing throughput using wafer or large panel reconstitution instead of strip/unit form reconstitution (e.g., chip bond, molding).

By adding protection to a substrate's sidewalls, systems and methods described herein may avoid substrate cracking or chipping during handling or in the event of collision to package. These systems and methods may also protect against electrical events (e.g., electromagnetic discharge or "ESD," radio frequency or "RF" noise from other chips, etc.), environmental elements (e.g., moisture, heat, etc.), and physical stresses (e.g., sidewall or backside chipping), thus improving overall reliability.

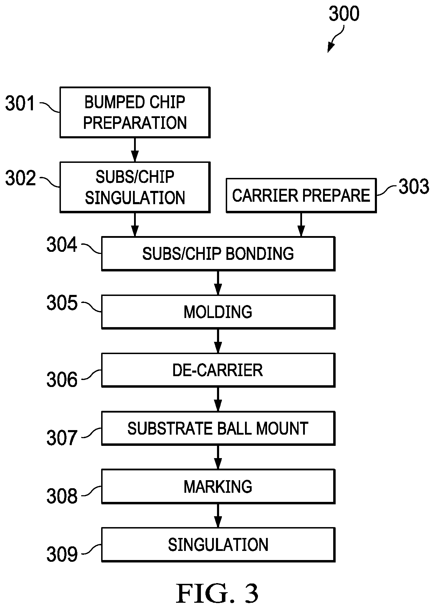

FIG. 3 is a flowchart of an example of process 300 or fabricating a semiconductor package with five-side mold protection. In some embodiments, process 300 may be employed to construct a flip chip package in wafer level or large panel reconstitution such that all mold embedded elements (including substrate, bumped chips, passives, etc.) may be singulated for feeding a chip bond process.

Particularly, process 300 begins at 301 with the preparation of bumped chips on a semiconductor wafer. At 302, process 300 singulates a substrate and chip(s). At 303, process 300 prepares a temporary carrier. At 304, process 300 bonds the chip(s) and substrate to the prepared temporary carrier.

At 305, process 300 adds a compound mold to form a package. At 306, process 300 debonds the carrier from the package. At 307, process 300 forms ball mounts on the bottom surfaces of the substrates of each package. At 308, process 300 includes marking each molded package. Then, at 309, process 200 singulates each molded package.

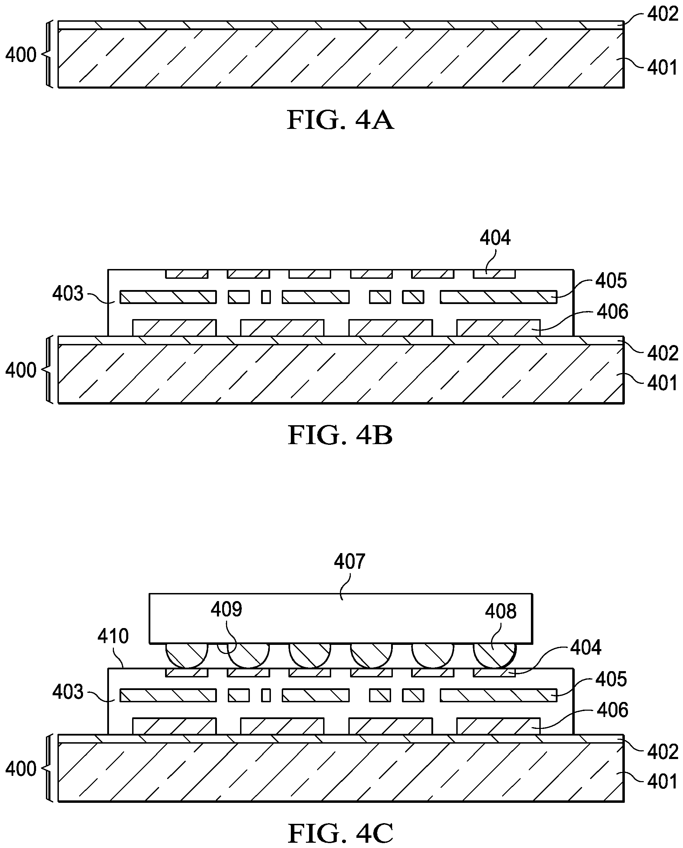

FIGs. 4A-E are cross-sectional views illustrating selected operations of process 300 for fabricating semiconductor package 416 with five-side mold protection. In FIG. 4A, a mold carrier may be prepared with sacrificial layer 402 deposited over glass wafer 401 to produce prepared mold carrier 400. Sacrificial layer 402 may include a conductive metallic material, a polymer, or a combination thereof (e.g., aluminum, copper, steel, iron, bronze, brass, polyimide, polyetherimide, fluoropolymer, etc.).

In FIG. 4B, substrate or lead frame 403 may be attached to prepared mold carrier 400. Substrate or lead frame 403 may include bond pads 404, redistribution layer (RDL) 405, and substrate terminals 406. Conductive structures (*e.g*., traces, pads, interconnects, vias, pads, etc.) may be formed from an electrically conductive material, examples of which include, but are not limited to: nickel, gold, copper, aluminum, tin, silver, titanium, or other suitable conductive metal or alloy composed of one or more suitable conductive metals.

In FIG. 4C, flip chip or bumped die 407 is attached to substrate or lead frame 403 such that the chip's solder bumps 408 are coupled to bond pads 404-that is, frontside 409 of flip chip or bumped die 407 faces top surface 410 of substrate or lead frame 403. At this stage, the assembly may undergo a reflow operation or the like.

Flip chip or bumped die 407 may be singulated from a semiconductor wafer, which can be any semiconductor material or combinations of materials, such as gallium arsenide, silicon germanium, silicon-on-insulator (SOI), silicon, monocrystalline silicon, the like, and combinations of the above. Such a semiconductor die includes active circuitry, which may include integrated circuit (IC) components that are active when the die is powered.

Active circuitry is formed on the semiconductor wafer using a sequence of numerous operations applied including, but not limited to: depositing semiconductor materials including dielectric materials and metals, such as growing, oxidizing, sputtering, and conformal depositing, etching semiconductor materials, such as using a wet etchant or a dry etchant, planarizing semiconductor materials, such as performing chemical mechanical polishing or planarization, performing photolithography for patterning, including depositing and removing photolithography masks or other photoresist materials, ion implantation, annealing, and the like.

In some embodiments, the active circuitry of a die may be a combination of IC components or may be another type of microelectronic device. Examples of IC components include but are not limited to a processor, memory, logic, oscillator, analog circuitry, sensor, microelectromechanical systems (MEMS) device, a standalone discrete device such as a resistor, inductor, capacitor, diode, power transistor, and the like.

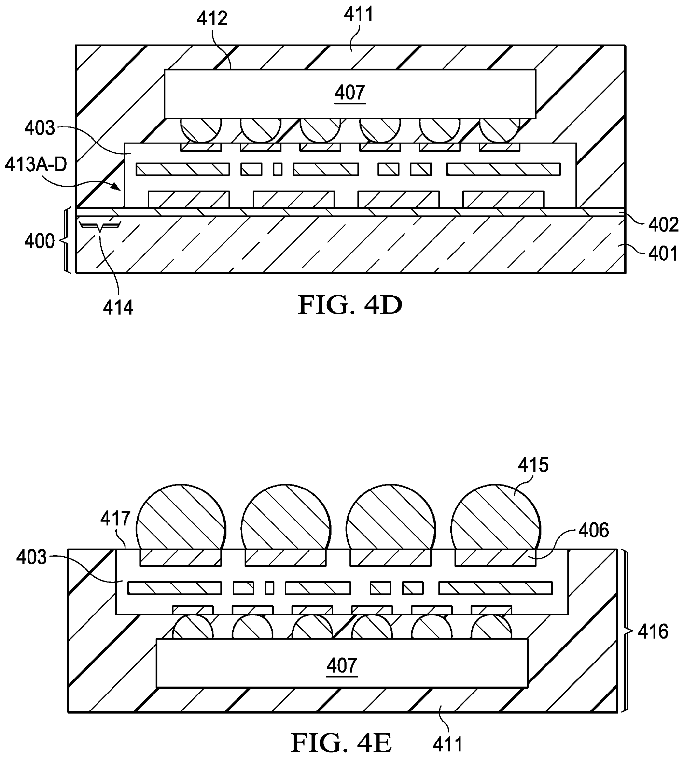

In FIG. 4D, mold compound 411 may be deposited, compressed, evaporated, or otherwise fabricated to encapsulate backside 412 of silicon (*e.g*., bulk silicon) of flip chip or bumped die 407 and four sidewalls 413A-D of substrate or lead frame 403. In some cases, the thickness 414 of mold compound 411 may be selected depending upon the application and/or level of protection desired. For example, thickness 414 may be selected based upon the RF spectrum in the location where the package is expected to be deployed, or the type of application (e.g., military vs. consumer).

After demolding of prepared mold carrier 400 from substrate or lead frame 403 (*e.g*., using laser ablation, etc.) and fabrication of solder bumps 415 on substrate terminals 406, FIG. 4E shows semiconductor package 416 with five-side mold protection. Semiconductor package 416 is then subject to Die Process Service(s) (DPS) operations such as, for example: griding, laser marking, singulation, chip sorting, etc.

Here it should be noted that the height or depth (in the z-axis) of mold compound 411 is aligned with, and does not go beyond, the bottom surface 417 of substrate or lead frame 403. That is, bottom surface 417 of substrate or lead frame 403 remains uncovered by mold compound 411 added in FIG. 4D.

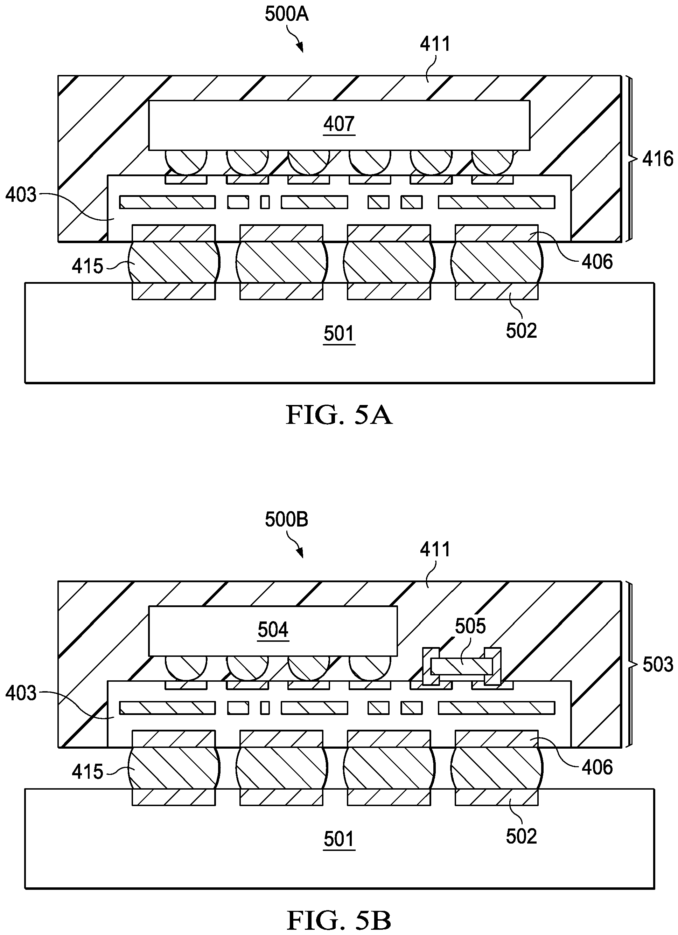

FIGs. 5A and 5B are cross-sectional views illustrating examples of electronic devices with semiconductor dies in a flip chip configuration having semiconductor packages with five-side mold protection. Specifically, in FIG. 5A, semiconductor package 416 with five-side mold protection of FIG. 4G is attached to PCB 501 of electronic device 500A such that solder bumps 415 are coupled to PCB terminals 502 to provide access to substrate terminals 406, and therefore flip chip 407.

In FIG. 5B, semiconductor package 503 including flip chip 504 and passive electronic component 505 with five-side mold protection is attached to PCB 501 of electronic device 500B, such that solder bumps 415 are coupled to PCB terminals 502 to provide access to chip 504.

As such, systems and methods described herein may provide a molding compound/underfill that covers up all bumped chips or passives and all sidewalls of the substrate carrier, exposing only solder bump mounts to PCBs. Although the X-Y size of a semiconductor package with five-side mold protection may be larger than a conventional package, the thickness of the two types of packages is the same. These systems and methods may enable higher manufacturing volume as it enables the use of wafer level and/or large panel reconstitution instead of flip chip strips or units. Moreover, these systems and methods provide improved performance because of greater resistance to damage, particularly when there are substrate cracking or chipping concerns, as well as less moisture and electrical noise due to the lateral mold protection isolation of functional chips/substrate from other chips and the environment.

In the embodiments shown, semiconductor packages 416 and 503, for example, are a chip scale packaging (CSP) packages that can be attached to a carrier, such as a PCB or a substrate, such as a laminate substrate or ceramic substrate, or another package. CSP packages generally have a package footprint equal to or less than 1.2 times the die footprint, and may have a pitch equal or less than 0.8 mm.

While certain embodiments described herein show a wafer level CSP package, systems and methods described herein may also be applicable to other package types, such as a fan out wafer level packaging (FOWLP) package, a ball grid array (BGA) package, or other package types that are otherwise configured to be attached by joints (*e.g*., solder balls, solder bumps such as C4 bumps, Cu pillars, Cu studs, or other conductive metal joints) to a suitable surface (*e.g*., a PCB, a substrate, a lead frame, an interposer, or another package). An example wafer level chip scale packaging (WLCSP) fabrication process for a package that includes formation of an underfill structure.

In an illustrative, non-limiting embodiment, a semiconductor package may include: a substrate comprising a top surface, a bottom surface, and four sidewalls; an electrical component comprising a backside and a frontside, where the frontside of the electrical component is coupled to the top surface of the substrate; and a molding compound, where the molding compound encapsulates the backside of the electrical component and the four sidewalls of the substrate.

For example, the substrate may include a lead frame. Additionally, or alternatively, the substrate may include a re-distribution layer. The frontside of the electrical component may be coupled to the top surface of the substrate via one or more solder bumps. The molding compound may not encapsulate the bottom surface of the substrate.

Moreover, the electrical component may include a semiconductor die in a flip chip configuration. The electrical component may also include a passive device coupled to the semiconductor die, and the molding compound may encapsulate the passive device.

In another illustrative, non-limiting embodiment, a method may include receiving an assembly comprising: a carrier, a substate coupled to the carrier, and a semiconductor die in a flip chip configuration coupled to a substrate; encapsulating the semiconductor die and all sidewalls of the substrate with a mold compound to produce an encapsulated assembly; and de-bonding the carrier from the encapsulated assembly.

In some implementations, an active side of the semiconductor die may be coupled to the substrate via one or more solder bumps. The molding compound may not encapsulate the bottom surface of the substrate. The method may also include encapsulating a passive device coupled to the semiconductor die with the mold compound.

In yet another illustrative, non-limiting embodiment, an electronic device may include a PCB and a semiconductor package coupled to the PCB, the semiconductor package including: a substrate having a top surface, a bottom surface, and a plurality of sidewalls; an electrical component having a frontside and a backside, where the frontside of the electrical component is coupled to the top surface of the substrate; and a molding compound, where the molding compound encapsulates the backside of the electrical component and the plurality of sidewalls of the substrate.

Again, the frontside of the electrical component may be coupled to the top surface of the substrate via one or more solder bumps. The molding compound may not encapsulate any portion of the bottom surface of the substrate.

The electrical component may include a semiconductor die in a flip chip configuration. The electrical component may also include a passive electrical device coupled to the semiconductor die, where the molding compound encapsulates the passive device.

In many implementations, systems and methods described herein may be incorporated into a wide range of electronic devices including, for example, computer systems or Information Technology (IT) products such as servers, desktops, laptops, memories, switches, routers, etc.; telecommunications hardware; consumer devices or appliances such as mobile phones, tablets, wearable devices, loT devices, television sets, cameras, sound systems, etc.; scientific instrumentation; industrial robotics; medical or laboratory electronics such as imaging, diagnostic, or therapeutic equipment, etc.; transportation vehicles such as automobiles, buses, trucks, trains, watercraft, aircraft, etc.; military equipment, etc. More generally, these systems and methods may be incorporated into any device or system having one or more electronic parts or components.

Although the invention(s) is/are described herein with reference to specific embodiments, various modifications and changes can be made without departing from the scope of the present invention(s), as set forth in the claims below. Accordingly, the specification and figures are to be regarded in an illustrative rather than a restrictive sense, and all such modifications are intended to be included within the scope of the present invention(s). Any benefits, advantages, or solutions to problems that are described herein with regard to specific embodiments are not intended to be construed as a critical, required, or essential feature or element of any or all the claims.

Reference is made herein to "configuring" a device or a device "configured to" perform some operation(s). It should be understood that this may include selecting predefined logic blocks and logically associating them. It may also include programming computer software-based logic of a retrofit control device, wiring discrete hardware components, or a combination of thereof. Such configured devices are physically designed to perform the specified operation(s).

Unless stated otherwise, terms such as "first" and "second" are used to arbitrarily distinguish between the elements such terms describe. Thus, these terms are not necessarily intended to indicate temporal or other prioritization of such elements. The terms "coupled" or "operably coupled" are defined as connected, although not necessarily directly, and not necessarily mechanically. The terms "a" and "an" are defined as one or more unless stated otherwise. The terms "comprise" (and any form of comprise, such as "comprises" and "comprising"), "have" (and any form of have, such as "has" and "having"), "include" (and any form of include, such as "includes" and "including") and "contain" (and any form of contain, such as "contains" and "containing") are open-ended linking verbs. As a result, a system, device, or apparatus that "comprises," "has," "includes" or "contains" one or more elements possesses those one or more elements but is not limited to possessing only those one or more elements. Similarly, a method or process that "comprises," "has," "includes" or "contains" one or more operations possesses those one or more operations but is not limited to possessing only those one or more operations.

## Claims

1. A semiconductor package, comprising:
a substrate comprising a top surface, a bottom surface, and four sidewalls;
an electrical component comprising a backside and a frontside, wherein the frontside of the electrical component is coupled to the top surface of the substrate; and
a molding compound, wherein the molding compound encapsulates the backside of the electrical component and the four sidewalls of the substrate.

2. The semiconductor package of claim 1, wherein the substrate comprises a lead frame.

3. The semiconductor package of claim 1 or 2, wherein the substrate comprises a re-distribution layer.

4. The semiconductor package of any preceding claim, wherein the frontside of the electrical component is coupled to the top surface of the substrate via one or more solder bumps.

5. The semiconductor package of any preceding claim, wherein the molding compound does not encapsulate the bottom surface of the substrate.

6. The semiconductor package of any preceding claim, wherein the electrical component comprises a semiconductor die in a flip chip configuration.

7. The semiconductor package of claim 6, wherein the electrical component further comprises a passive device coupled to the semiconductor die, and wherein the molding compound encapsulates the passive device.

8. An electronic device, comprising:
a Printed Circuity Board, PCB; and
a semiconductor package as claimed in any preceding claim, wherein the semiconductor package is coupled to the PCB.

9. A method, comprising:
receiving an assembly comprising: a carrier, a substate coupled to the carrier, and a semiconductor die in a flip chip configuration coupled to a substrate;
encapsulating the semiconductor die and all sidewalls of the substrate with a mold compound to produce an encapsulated assembly; and
de-bonding the carrier from the encapsulated assembly.

10. The method of claim 9, wherein the substrate comprises a lead frame.

11. The method of claim 9 or 10, wherein the substrate comprises a re-distribution layer.

12. The method of any of claims 9 to 11, wherein an active side of the semiconductor die is coupled to the substrate via one or more solder bumps.

13. The method of any of claims 9 to 12, wherein the molding compound does not encapsulate the bottom surface of the substrate.

14. The method of any of claims , further comprising encapsulating a passive device coupled to the semiconductor die with the mold compound.
